# EUROPÄISCHE PATENTSCHRIFT

(11) **EP 0 395 679 B1**
(45) Veröffentlichungstag und Bekanntmachung des Hinweises auf die Patenterteilung: **02.03.1994**
(21) Anmeldenummer: 88909739.0
(22) Anmeldetag: 12.11.1988
(51) Int. Cl.: G01R 31/28, H01J 37/00, G06F 11/00

(54) **VERFAHREN UND ANORDNUNG ZUR MESSUNG DES SIGNALVERLAUFS AN EINEM MESSPUNKT EINER PROBE**
PROCESS AND ARRANGEMENT FOR MEASURING THE VARIATION OF A SIGNAL AT A MEASURING POINT OF A SPECIMEN
PROCEDE ET DISPOSITIF DE MESURE DE LA VARIATION DANS LE TEMPS DE SIGNAUX A LA POINTE DE MESURE D'UN SPECIMEN

(30) Priorität: 12.11.1987 DE 3738453
(43) Veröffentlichungstag der Anmeldung: 07.11.1990
(73) Patentinhaber: Brust, Hans-Detlef, D-66125 Saarbrücken (DE)
(72) Erfinder: Brust, Hans-Detlef, D-66125 Saarbrücken (DE)
(74) Vertreter: Münich, Wilhelm, Dr.
(86) Internationale Anmeldenummer: DE8800707
(87) Internationale Veröffentlichungsnummer: WO8904493

(56) Entgegenhaltungen:
- US-A- 4 220 853
- US-A- 4 223 220
- Microelectronic Engineering, Band 4, 1986, seiten 77-106, E. Wolfgang: "Electronic Beam Testing"
- Scanning, Band 5, 1983, Seiten 14-24, H.P. Feuerbaum: "Electron Beam Testing: Methods and Applications"
- Scanning Electron Microscopy/1979/I, SEM Inc., AMF O'Hare, Seiten 305-317, E. Menzel et al.: "Electron Beam Chopping Systems in the SEM"
- The Review of Scientific Instruments, band 39, September 1968, Seiten 1342-1345, R. Nutt: "Digital Time Intervalometer"

## Beschreibung

### Technisches Gebiet

Die Erfindung betrifft ein Verfahren und eine Anordnung zur Messung des Signalverlaufs an einem Meßpunkt einer Probe mit Hilfe einer Korpuskularsonde.

### Stand der Technik

Die Überprüfung der Funktionsweise hochintegrierter Schaltungen erfolgt üblicherweise in rechnergesteuerten Halbleitertestsystemen, sogenannten Funktionstestern, in denen Fehler der integrierten Schaltung durch Analyse der an den Ausgängen der untersuchten Schaltung in Abhängigkeit von den jeweils eingespeisten Bitmustern gemessenen Spannungspegel zwar erkannt, aber nur sehr schwer lokalisiert werden können. Deshalb müssen insbesondere während der Entwicklungsphase zusätzliche Untersuchungen und Messungen im Innern der hochintegrierten Schaltungen durchgeführt werden.

Als für diese Zwecke besonders geeignet haben Sich die in allen Bereichen der Entwicklung und Fertigung mikroelektronischer Bauelemente eingesetzten Korpuskularstrahl-Meßverfahren, und hier wieder insbesondere die Elektronenstrahl-Meßtechnik, erwiesen. Bei diesen Meßtechniken richtet man einen fein fokussierten Korpuskularstrahl auf den Meßpunkt und registriert die entstehenden Sekundärkorpuskeln bzw. ein abgeleitetes sekundäres Signal, die durch den zu messenden Signalverlauf am Meßort beeinflußt werden. Eine Zusammenfassung der zur Zeit gewöhnlich eingesetzten Testverfahren der Elektronenstranl-Meßtechnik ist in der Veröffentlichung "Electron Beam Testing" von E. Wolfgang (Zeitschrift "Microelectronic Engineering", Band 4, 1986, Seiten 77 - 106) wiedergegeben. Eines der wichtigsten Meßverfahren der Elektronenstrahl-Meßtechnik ist dabei die sogenannte Waveform-Messung, die ausführlich in der Veröffentlichung "Electron Beam Testing: Methods and Applications" von H.-P. Feuerbaum (Zeitschrift "Scanning", Band 5, 1983, Seiten 14 - 24) insbesondere auf den Seiten 12 bis 14 beschrieben ist und mit deren Hilfe der Spannungsverlauf an einem Meßpunkt einer Probe gemessen werden kann. Von dieser Druckschrift wird bei der Formulierung des Oberbegriffs der Ansprüche 1 und 23 ausgegangen. Bei der Waveform-Messung richtet man einen fein fokussierten Elektronenstrahl auf die zu untersuchende Meßstelle der integrierten Schaltung. Die dort auftreffenden Primärelektronen lösen aus der Probenoberfläche Sekundärelektronen aus, die durch die elektrischen Potentiale auf der Probenoberfläche beeinflußt werden. Diese Beeinflussung äußert sich in einem Sekundärelektronenstrom, der vom Potential am Meßort abhängt, bzw. einer Energieverschiebung der Sekundärelektronen, die ebenfalls vom elektrischen Potential am Meßort bestimmt wird und mit Hilfe eines Energiespektrometers gemessen werden kann. Diesen Effekt bezeichnet man als Potentialkontrast. Da die zur Registrierung der Sekundärelektronen erforderlichen Detektoren gewöhnlich nur eine relativ geringe Bandbreite von einigen MHz aufweisen, muß zur Erzielung einer hohen Zeitauflösung ein Abtastverfahren eingesetzt werden, bei dem der zeitliche Verlauf des Signals am Meßort ähnlich wie bei einem Sampling-Oszilloskop mit kurzen Elektronenpulsen auf ein Triggerereignis hin abgetastet wird. Da jeder Primärelektronenpuls nur sehr wenige Elektronen enthalten kann, muß zur Erzielung eines ausreichenden Signal-Rausch-Verhältnisses über die Abtastwerte aus sehr vielen Meßzyklen gemittelt werden, was zu sehr langen Meßzeiten führen kann. Dieses Verfahren eignet sich somit nur zur Untersuchung periodisch wiederkehrender Signale.

Da bei der Waveform-Messung auf ein Triggerereignis hin ein Elektronenpuls erzeugt wird, bestimmt die Triggerfrequenz die erforderliche Meßzeit. Aus diesem Grund liefert die Waveform-Messung bei niedrigen Triggerfrequenzen nur relativ ungenaue Ergebnisse, wenn man keine überlangen Meßzeiten tolerieren will. Dies ist besonders dann außerordentlich nachteilig, wenn man die integrierte Schaltung zur Reproduktion des Fehlers im gleichen Testzyklus wie im Funktionstester betreiben möchte, denn die Testzyklen der Funktionstester sind im allgemeinen relativ lang und wiederholen sich somit nur mit sehr niedriger Frequenz. Außerdem können nur Vorgänge untersucht werden, die nach dem Triggerereignis auftreten. Vielfach sind aber demgegenüber gerade die Vorgänge vor dem Triggerereignis von besonderem Interesse. Dies gilt z.B. dann, wenn man die integrierte Schaltung von einem Halbleitertester ansteuern lassen und das Ausgangssignal des Funktionstesters, das angibt, ob der Baustein ordnungsgemäß arbeitet oder nicht, als Triggersignal benutzen möchte. Das Triggerereignis wäre also in diesem Beispiel das Auftreten eines Fehlers in der Arbeitsweise der integrierten Schaltung beispielsweise das fehlerhafte Auslesen einer Speicherzelle. Es ist leicht einsichtig, daß in diesem Fall der Signalverlauf am jeweiligen Meßort vor dem Triggerereignis, der Rückschlüsse auf die Fehlerursache zulaßt, von besonderem Interesse ist. Zwar ist es prinzipiell möglich mit dem Triggersignal aus einem Zyklus den Elektronenpuls für den nächsten Zyklus zu erzeugen und so scheinbar auch Messungen vor dem Triggerereignis durchzuführen, doch führt dies vor allem bei längeren Testzyklen nicht selten zu Jitterproblemen. Außerdem lassen sich mit diesem Verfahren dann nur periodisch wiederkehrende Vorgänge untersuchen. Bei wiederholt wiederkehrenden Vorgängen, die nur statistisch verteilt auftreten, versagt dagegen dieses Verfahren. Derartige nur statistisch auftretende Vorgänge können in integrierten Schaltungen beispielsweise durch den Einfall von α-Teilchen hervorgerufen werden. Außerdem treten derartige Vorgänge häufig auf, wenn die integrierte Schaltung an der Grenze ihrer Leistungsfähigkeit betrieben wird (sogenannter "Marginal Test") und sehr viele nur schwer zu beeinflussende Faktoren die Funktion des Bauelements beeinflussen. In allen diesen Fällen versagt die herkömmliche Waveform-Messung.

### Darstellung der Erfindung

Der Erfindung liegt die Aufgabe zugrunde, ein Verfahren und eine Anordnung zur Messung des Signalverlaufs an einem Meßpunkt anzugeben, mit deren Hilfe es möglich ist, auch Signalverläufe zu messen, die mit nur sehr geringer Wiederholfrequenz und überdies unter Umständen auch nur statistisch verteilt auftreten. Die Erfindung soll weiterhin ermöglichen, dabei auch Vorgänge zu untersuchen, die vor dem Triggerereignis liegen.

Diese Aufgabe wird erfindungsgemäß durch ein Verfahren nach Anspruch 1 und eine Anordnung nach Anspruch 23 gelöst. Ausgestaltungen und Vorteile der Erfindung sind in den Unteransprüchen, der Beschreibung und den Zeichnungen dargestellt.

Der mit der Erfindung erzielbare Vorteil liegt insbesondere darin, daß auch der Signalverlauf von Vorgängen, die nur mit geringer Wiederholrate auftreten, selbst dann mit hoher Genauigkeit gemessen werden kann, wenn der zu untersuchende Vorgang nicht periodisch, sondern nur statistisch verteilt wiederkehrt. Dadurch wird die Ankopplung eines Funktionstesters an ein Elektronenstrahlmeßgerät sehr erleichtert und der Vergleich der Meß- bzw. Testergebnisse beider Geräte wird vereinfacht, was erheblich zu einer schnelleren und sehr effektiven Fehlersuche beiträgt.

### Kurze Beschreibung der Zeichnung

Die Erfindung wird nachfolgend anhand der Zeichnungen näher erläutert. Dabei zeigen:
- Fig. 1: das Arbeitsprinzip des herkömmlichen Verfahrens der Waveform-Messung nach dem Stand der Technik,
- Fig. 2: das Arbeitsprinzip des erfindungsgemäßen Verfahrens zur Messung des Signalverlaufs an einem Meßort,
- Fig. 3: eine Anordnung zur Durchführung des erfindungsgemäßen Verfahrens,
- Fig. 4: einen Strahlaustastgenerator, wie er in der Anordnung nach Fig. 3 verwendet werden kann,
- Fig. 5: eine Ausgestaltung der Elektronenquelle, wie sie in der Anordnung nach Fig. 3 eingesetzt werden kann, und
- Fig. 6: eine Weiterbildung der Signalverarbeitungsanordnung aus der Anordnung von Fig. 3.

### Darstellung von Ausführungsbeispielen

Obwohl sich die folgenden Ausfürungsbeispiele auf ein Elektronenstrahl-Meßgerät beziehen, ist die Erfindung so zu verstehen, daß anstelle von Elektronen auch Ionen oder andere Korpuskel verwendet werden können, und zwar sowohl als Primärkorpuskel als auch als Sekundärkorpuskel.

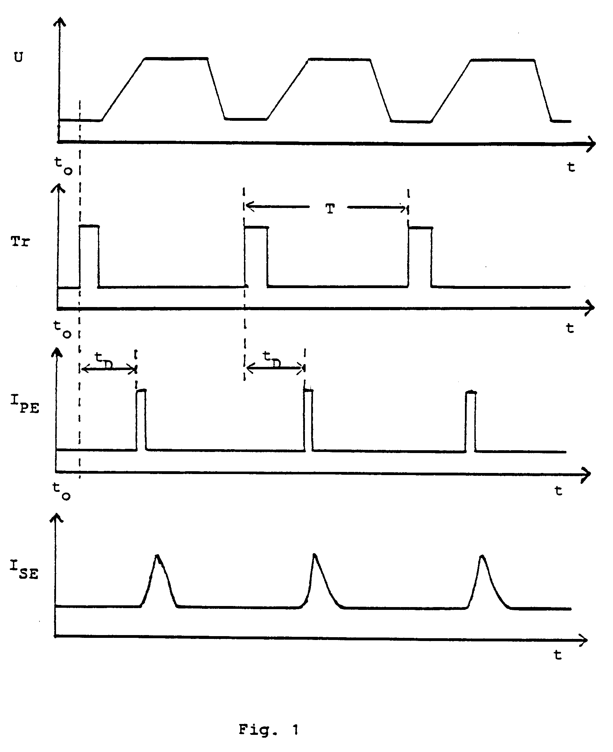

Fig. 1 verdeutlicht das Arbeitsprinzip der herkömmlichen Waveform-Messung nach dem Stand der Technik, wie sie beispielsweise in der zitierten Veröffentlichung von H.-P. Feuerbaum beschrieben ist. Der mit der Periodendauer T periodisch sich wiederholende Signalverlauf U soll gemessen werden. Dazu muß in der zu untersuchenden Probe oder deren Ansteuerung ein Triggersignal Tr erzeugt werden, das das Auftreten des zu messenden Vorganges einleitet und anzeigt. Auf einen solchen Triggerimpuls hin wird dann nach einer Verzögerungszeit t_{D} ein Primärelektronenimpuls erzeugt, was zu einem pulsförmigen Primärelektronenstrom als Primärstrahlstrom I_{PE} führt. Jeder Primärelektronenimpuls erzeugt einen Sekundärelektronenimpuls, so daß ein entsprechender pulsförmiger Sekundärelektronenstrom I_{SE} entsteht. Die geringe Zeitverschiebung zwischen Primär- und Sekundärelektronenpulsen ist dabei auf die Laufzeit der Elektronen zwischen Elektronenquelle und Probe bzw. zwischen Probe und Detektor zurückzuführen. Die erreichbare Zeitauflösung wird bei diesem Verfahren nur noch durch die Breite der Primärelektronenimpulse, aber nicht mehr durch die Bandbreite des Detektionssystems, mit dem der Sekundärelektronenstrom registriert wird, bestimmt. Durch langsame Verschiebung des Zeitpunktes, zu dem ein Primärelektronenimpuls erzeugt und damit eine Abtastung des Signalverlaufs vorgenommen wird, also durch Variation der Verzögerungszeit t_{D}, kann der gesamte interessierende Signalverlauf abgetastet werden. Die Geschwindigkeit, mit der die Zeitverzögerung t_{D} verändert wird, bestimmt dabei, über wieviele Abtastwerte bzw. Meßzyklen pro Zeitpunkt gemittelt wird. Wie man deutlich erkennt, ist das Signal-Rausch-Verhältnis bei diesem Verfahren relativ ungünstig, da der Primär-Korpuskularstrahl fast ständig ausgetastet ist und somit nur in geringer Bruchteil des maximal möglichen Primärelektronenstroms bzw. Primärstrahlstroms die Probe erreicht. Je größer die Periodendauer T ist, desto schlechter wird das Signal-Rausch-Verhältnis, was entweder zu längeren Meßzeiten oder einer erhöhten Meßungenauigkeit führt. Außerdem werden die Primärelektronenimpulse, die die Abtastung des Signalverlaufs bewirken, erst durch den Triggerimpuls ausgelöst und erscheinen folglich erst nach dem Triggerimpuls. Messungen vor dem Triggerimpuls können somit nicht vorgenommen werden.

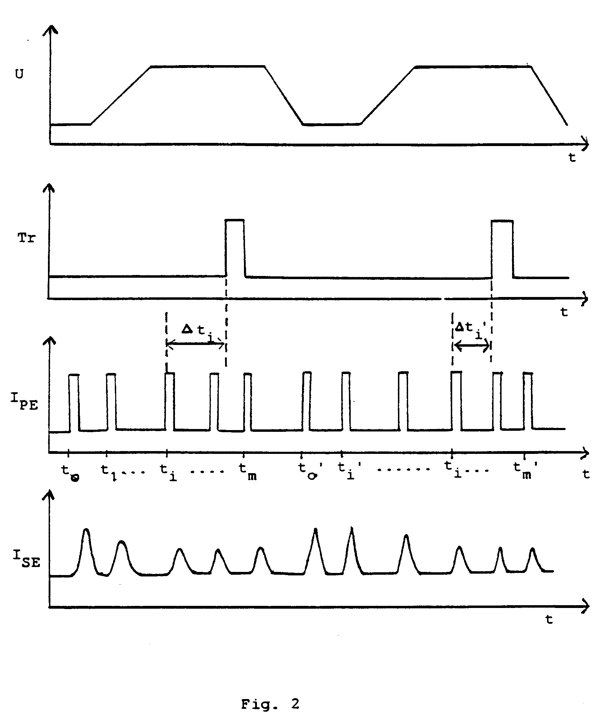

Demgegenüber zeigt Fig. 2 das Arbeitsprinzip des erfindungsgemäßen Verfahrens, das die genannten Nachteile nicht aufweist. Wie bereits beim konventionellen Meßverfahren der Waveform-Messung wird auch beim erfindungsgemäßen Verfahren ein Primär-Korpuskularstrahl auf die Probe gerichtet und das Vorliegen des interessierenden Vorgangs wird ebenfalls durch ein Triggersignal Tr angezeigt. Im Gegensatz zum herkömmlichen Abtastverfahren braucht der Triggerimpuls aber keineswegs den Beginn des zu messenden Vorgangs anzuzeigen, sondern der Triggerimpuls kann beliebig vor, während oder nach dem zu messenden Vorgang erscheinen. Völlig unabhängig von dem zu messenden Signalverlauf und dem Triggerimpuls werden Primärelektronenimpulse erzeugt. Nach welcher Zeitfunktion dies geschieht, wie also der zeitliche Verlauf des Primärstrahlstromes I_{PE} aussieht, ist dabei prinzipiell beliebig, doch ist es vorteilhaft, wenn diese Zeitfunktion, in Fig. 2 also die Abtastzeitpunkte t_{O}, t₁, ..., tₘ, bekannt ist. Die durch die Primärelektronenimpulse erzeugten Sekundärelektronenimpulse werden detektiert und die entsprechenden Stromwerte werden abgespeichert. Um die so registrierten Abtastwerte zur Auswertung der Messung wieder richtig ihren zeitlichen Positionen im zu messenden Signalverlauf U zuordnen zu können, wird die zeitliche Lage des Triggerimpulses zur Zeitfunktion des Primärstrahlstromes I_{PE} gemessen. Falls die Zeitfunkton des Primärstrahlstromes I_{PE} bekannt ist, genügt es dazu, beispielsweise wie in Fig. 2 gezeigt, den zeitlichen Abstand zwischen dem Triggerimpuls und dem nächsten Puls des Primärstrahlstromes zu messen. Die zeitliche Lage der übrigen Abtastwerte in Bezug auf den zu messenden Signalverlauf läßt sich dann einfach aus der bekannten Zeitfunktion des Primärstrahlstromes I_{PE} berechnen, da ja die Zeitpunkte t_{O}, t₁, ..., tₘ und damit die zeitliche Lage der Abtastwerte bezogen auf die Referenzwerte tᵢ bzw. t'ᵢ bekannt sind. Die zeitliche Lage bezogen auf den zu messenden Signalverlauf erhält man somit einfach durch Subtraktion der gemessenen Zeitdifferenzen t bzw. t'zwischen Triggerimpuls und Referenzpunkt tᵢ bzw. tᵢ. Ist die Zeitfunktion des Primärelektronenstromes dagegen nicht bekannt, muß der zeitliche Abstand jedes einzelnen Primärelektronenpulses zum Triggersignal gemessen und mit dem jeweiligen Abtastwert zusammen abgespeichert werden. Bei bekannter Zeitfunktion dagegen genügt es für eine ganze Gruppe von Abtastwerten nur eine einzige Zeitdifferenz t bzw. t' zu messen und zusammen mit der entsprechenden Gruppe von Meßwerten abzuspeichern. Dies ist natürlich wesentlich einfacher und erfordert weniger Aufwand. Zur Auswertung der Messung wird mit Hilfe der abgespeicherten Zeitdifferenzen ( t, t') die zeitliche Position jedes Abtastwertes in Bezug auf den Zeitverlauf des zu messenden Signals U errechnet und dann der Abtastwert zur Ermittlung des Signalwertes an diesem Zeitpunkt herangezogen. Da gewöhnlich mehrere Abtastwerte auf einen Zeitpunkt des Signalverlaufs U fallen, wird eine Mittelung durchgeführt, die das Signal-Rausch-Verhältnis verbessert.

Wie man aus Fig. 2 unmittelbar ersieht, werden pro Triggerereignis nicht nur eine, sondern viele Abtastungen des Signalverlaufs U durchgeführt. Aus diesem Grund liefert das erfindungsgemäße Verfahren bei gleicher Meßzeit ein wesentlich besseres Signal-Rausch-Verhältnis und damit eine höhere Meßgenauigkeit als die herkömmliche Waveform-Messung. Daher ist dieses Verfahren auch bei sehr niedrigen Triggerfrequenzen sinnvoll einsetzbar. Das Signal-Rausch-Verhältnis ist dabei umso besser, je näher die Primärelektronenimpulse zusammenliegen. Da der Sekundärelektronendetektor die einzelnen Sekundärelektronenimpulse trennen können muß, bestimmt die Bandbreite des benutzten Detektionssystems den minimalen Abstand zweier Primärelektronenimpulse. Da die Erzeugung der Primärelektronenimpulse unabhängig von einem Triggerereignis erfolgt, werden stets auch Abtastungen vor dem Triggerimpuls vorgenommen. Daher ist die zeitliche Lage des Triggerimpulses bezogen auf den zu messenden Vorgang, solange diese zeitliche Position nur konstant ist, unerheblich. Da sich die Messung von Zeitdifferenzen mit sehr hoher Präzision und Zeitauflösung durchführen läßt, kann das Triggerereignis auch erst sehr spät nach dem zu messenden Vorgang auftreten. So ist es beispielsweise möglich, mit dem erfindungsgemäßen Verfahren einen Signalverlauf im ns-Bereich zu messen, obschon das Triggersignal erst einige ms nach dem zu messenden Vorgang erscheint. Mit der herkömmlichen Waveform-Messung wäre eine solche Messung dagegen praktisch unmöglich. Wenn man die Messung nach dem erfindungsgemäßen Verfahren über sehr viele Zyklen durchführt, wird wegen der Unabhängigkeit von zu messendem Signalverlauf und Primärelektronenstrom bzw. Primärstrahlstrom jeder Zeitpunkt des Signalverlaufs U im Mittel gleich oft abgetastet. Eine Phasenschiebung bzw. Veränderung der Verzögerungszeit t_{D} wie bei der herkömmlichen Waveform-Messung ist nicht erforderlich.

Der wesentliche Grundgedanke des erfindungsgemäßen Verfahrens besteht also darin, nach einer bellebigen Zeitfunktion, die völlig unabhängig von der Probe und dem dort zu untersuchenden Vorgang sein darf, Primärelektronenimpulse zu erzeugen, die zugehörige Werte des Sekundärelektronenstromes bzw. eines entsprechenden sekundären Signals zu registrieren und durch eine Zeitintervallmessung zwischen der Zeitfunkton des Primärstrahlstromes und einem Triggersignal, das in einem definierten zeitlichen Zusammenhang mit dem zu untersuchenden Vorgang steht, einen zeitlichen Bezug zwischen registrierten Meßwerten und dem zu untersuchenden Vorgang herzustellen.

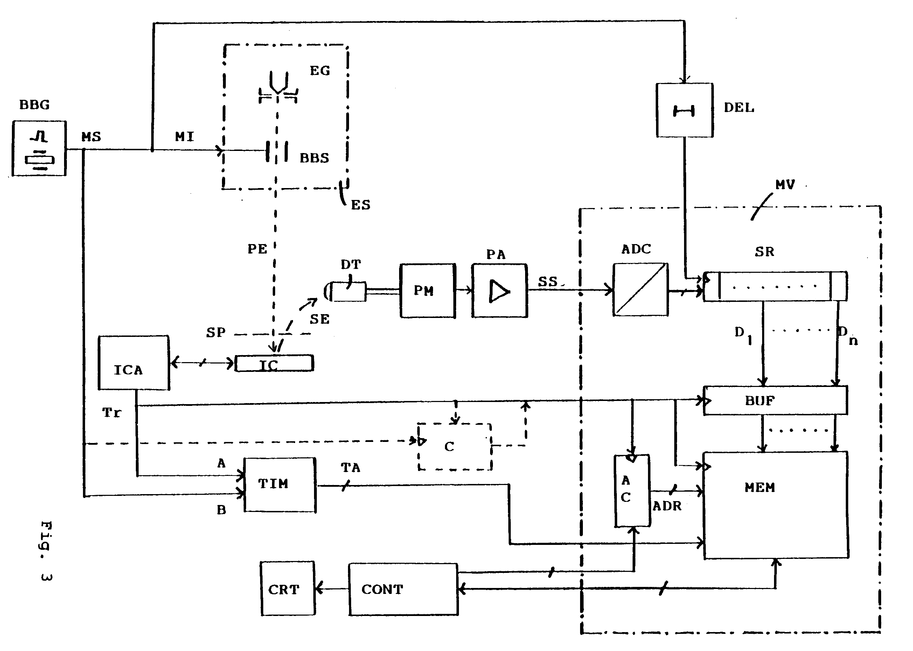

Figur 3 zeigt schematisch eine Anordnung, mit der das erfindungsgemäße Verfahren realisiert werden kann. Das Kernstück dieser Anordnung bildet ein beispielsweise aus den US-Patentschriften 4,220,853 und 4,223,220 bekanntes Elektronenstrahl-Meßgerät. In der elektronenoptischen Säule eines solchen Elektronenstrahl-Meßgeräts wird ein fein gebündelter Primär-Korpuskularstrahl PE erzeugt. Diese elektronenoptische Säule weist neben einer Vielzahl in der Figur 3 und den späteren Figuren aus Gründen der Übersichtlichkeit nicht dargestellten Blenden und elektrischen oder magnetischen Linsensystemen zur Strahlformung, Strahlablenkung und zur Strahlfokussierung eine Elektronenquelle ES, die die Primärelektronenimpulse erzeugt, auf.

Die Elektronenquelle ES hat die Aufgabe, die Primärelektronenimpulse zu generieren. In Figur 3 ist sie aus einer im wesentlichen aus einer Kathode, die die Primärelektronen durch thermische Emission erzeugt, einer Anode und einer Wehnelt-Elektrode bestehenden Elektronenkanone EG und einem Strahlmodulations- oder -austastsystem BBS aufgebaut. Mit Hilfe des Strahlmodulationssystems BBS wird der von der Kathode gelieferte kontinuierliche Primärelektronenstrom in seiner Intensität moduliert. Auf diese Weise können Primärelektronenimpulse erzeugt werden. Mögliche Ausführungsformen von Elektronenkanone EG und Strahlmodulationssystem BBS sind beispielsweise in der Veröffentlichung. "Electron beam chopping systems in the SEM" von E. Menzel und E. Kubalek (Scanning Electron Microscopy, SEM Inc., AMF O'Hare, 1979/I, Seiten 305-317) beschrieben.

Zur Erzeugung der Primärelektronenimpulse ist ein Strahlmodulationsgenerator BBG mit dem Modulationseingang MI der Elektronenquelle ES verbunden. Der Strahlmodulationsgenerator BBG steuert das Strahlmodulatlonssystem BBS mit einem Modulationssignal MS an. In dieser Realisierung besteht das Modulationssignal MS aus Rechteckimpulsen, die mit konstanter Wiederholfrequenz auftreten. Andere Möglichkeiten zur Ansteuerung des Strahlmodulationssystems mit unterschiedlichen Signalformen sind ebenfalls in der zitierten Veröffentlichung von E. Menzel und E. Kubalek beschrieben und könnten im Prinzip ebenfalls verwendet werden. Jeder Rechteckimpuls des Modulationssignals MS tastet den Primär-Korpuskularstrahl PE kurz ein und erzeugt so einen Primärelektronenimpuls. Die Breite der Rechteckimpulse bestimmt dabei die Dauer der Primärelektronenimpulse. Da die Primärelektronenimpulse periodisch mit einem bestimmten Zeitabstand aufeinanderfolgen, ist die Zeitfunktion des Primärstrahlstromes bekannt, was die spätere Auswertung der Meßergebnissse sehr erleichtert. Da in diesem Fall die Konstanz der Periodendauer, mit der die Primärelektronenimpulse erzeugt werden, entscheidend die Genauigkeit der Messung bestimmt, sollte der Strahlmodulationsgenerator, der das Modulationssignal MS erzeugt, eine hohe Frequenzkonstanz aufweisen. Am einfachsten kann man dies erreichen, wenn der Generator BBG quarzstabilisiert ist oder seinerseits von einer hochkonstanten Zeitbasis getriggert wird.

Die so erzeugten Primärelektronenimpulse werden dann durch die in Figur 3 nicht dargestellten Linsensysteme auf die Probe IC, beispielsweise eine integrierte Schaltung fokussiert. Dort lösen die auftreffenden Primarelektronen (d.h. der Primär-Korpuskularstrahl) PE Sekundärelektronen SE aus, die vom Detektor DT registriert und in Lichtimpulse umgewandelt werden. Diese Lichtimpulse werden dann über einen Lichtleiter zu dem gewöhnlich außerhalb der Probenkammer des Elektronenstrahlmeßgerätes befindlichen Photomultiplier PM geleitet, der die Lichtimpulse wieder in ein elektrisches Signal umsetzt, das dann, gegebenenfalls nach weiterer Verstärkung in einem dem Photomultiplier PM nachgeschalteten Vorverstärker PA, als (in diesem Fall elektrischen) sekundäres Signal SS zur weiteren Auswertung in einer Meßwertverarbeitungsanordnung MV zur Verfügung steht. Da die Sekundärelektronen SE durch das elektrische Potential am Meßort beeinflußt werden, wird auch das sekundäre Signal SS durch das Potential am Meßort und damit durch den zu messenden Spannungsverlauf U bestimmt.

Die zu untersuchende Probe IC wird zur Reproduktion des interessierenden Vorgangs, z. B. eines Fehlers, zyklisch betrieben. Dazu wird die Probe IC von einer Ansteuerung ICA mit Versorgungsspannungen und gegebenenfalls Eingangssignalen zur Stimulation versorgt. Als Ansteuerung ICA kann dabei insbesondere ein Funktionstester dienen, der dann auch die Ausgangssignale der Schaltung überwacht und dadurch feststellen kann, ob die Probe IC fehlerhaft arbeitet oder nicht. Die Ansteuerung oder die Probe selbst liefert auch das Triggersignal Tr, das anzeigt, das der zu untersuchende Vorgang in der Probe abläuft bzw. abgelaufen ist. Als Triggersignal kann dabei insbesondere das Fail-Signal eines Funktionstesters dienen, das anzeigt, daß die Probe IC fehlerhaft arbeitet. Um den Zeitlichen Zusammenhang zwischen diesem Vorgang und der Zeitfunktion des Primärelektronenstromes zu ermitteln, wird die Zeitdifferenz zwischen dem Triggersignal und dem nächsten Primärelektronenimpuls gemessen.

Da die Primärelektronenimpulse mit konstanter Wiederholfrequenz erzeugt werden, genügt eine einzige Zeitmessung, um die zeitliche Position einer ganzen Reihe von Meßwerten des sekundären Signals SS bezüglich des zu messenden Spannungsverlaufs zu ermitteln. Zur Messung der Zeitdifferenz dient ein Zeitintervallmesser TIM, dem sowohl das Triggersignal Tr als auch das Modulationssignal MS zugeführt wird. Als Zeitintervallmesser kann z. B. der Frequenzzähler 1995 der Firma Racal-Dana im Time-Interval (A-->B)-Modus eingesetzt werden. Ein weiterer Zeitinervallmesser ist in der Veröffentlichung "Digital time intervalometer" von R. Nutt (Review Scientific Instruments, Band 39, 1968, Seiten 1342-1345) beschrieben. Das Triggersignal Tr am Eingang A startet dann die Zeitintervallmessung, der nächste Rechteckimpuls des Modulationssignals MS am Eingang B, gleichbedeutend mit einem neuen Primärelektronenimpuls, stoppt sie. Das so ermittelte Meßergebnis TA der Zeitintervallmessung gibt dann zunächst die zeitliche Lage des nächsten Primärelektronenimpulses bzw. des korrespondierenden Wertes des sekundären Signals zum Triggerimpuls Tr und damit zum zu messenden Spannungsverlauf U an. Wegen des konstanten Abstands der Primärelektronenimpulse voneinander, läßt sich daraus aber leicht die zeitliche Lage der übrigen Primärelektronenimpulse und ihrer korrespondierenden Meßwerte des sekundären Signals bezogen auf den zu untersuchenden Vorgang berechnen. Sie ergibt sich einfach durch Addition bzw. Subtraktion des entsprechenden Vielfachen zum bzw. vom Ergebnis TA der Zeitmessung. Das Ergebnis der Zeitintervallmessung TA wird vorzugsweise digitalisiert ebenfalls der Meßwertverarbeitungsanordnung MV zugeführt und zusammen mit den zugehörigen registrierten Meßwerten des sekundären Signals SS aufgezeichnet.

Der Meßwertverarbeitungsanordnung MV kommt die Aufgabe zu, die zu den einzelnen Primärelektronenimpulsen gehörenden Werte des sekundären Signals SS zu registrieren, falls nötig zu verzögern und, falls ein Triggerereignis auftritt, zusammen mit dem zugehörigen Ergebnis TA der Zeitintervallmessung aufzuzeichnen. Dazu enthält die Meßwertverarbeitungsanordnung MV einen Analog-Digital-Wandler ADC, ein Schieberegister SR, eine schnelle Bufferschaltung BUF, einen Adreßzähler AC und eine Speichereinneit MEM. Der Analog-Digital-Wandler ADC ist mit dem Ausgang des Vorverstärkers PA verbunden und wandelt das sekundäre Signal SS in digitale Werte um. Angesichts der relativ hohen Wiederholfrequenz der Primärelektronenimpulse steht für die Analog-Digital-Wandlung nur wenig Zeit zur Verfügung. Daher empfiehlt sich der Einsatz schneller A/D-Wandler-Typen, beispielsweise eines Flash-A/D-Wandlers. Im einfachsten Fall besteht der Analog-Digital-Wandler ADC nur aus einem schnellen Komparator las 1-Bit-A/D-Wandler.

Das digitale Ausgangssignal des Analog-Digital-Wandlers ADC wird dann in ein schnelles Schieberegister SR eingelesen. Dazu ist der Ausgang des Analog-Digital-Wandlers mit dem bzw. den Eingängen des Schieberegisters SR verbunden. Sobald ein neuer Meßwert des sekundären Signals registriert werden muß, wird der vorhergehende Meßwert um eine Speicherstelle im Schieberegister weitergeschoben. Dazu wird der Takteingang des Schieberegisters SR ebenfalls mit dem gegebenenfalls verzögerten Modulationssignal MS versorgt. Eine Verzögerung kann durch ein vor dem Takteingang des Schieberegisters angeordnetes Verzögerungsglied bewirkt werden. Diese Verzögerung ist im allgemeinen erforderlich, um die Laufzeit der Primärelektronen PE zwischen dem Strahlmodulationssystem BBS und der Probe IC und die Laufzeit der Sekundärelektronen SE von der Probe IG zum Detektor sowie eventuelle Verzögerungszeiten der aus Detektor DT, Photomultiplier PM und Vorverstärker PA bestehenden Signalkette und des A/D-Wandlers zu kompensieren. Die Verzügerungszeit des Verzögerungsgliedes DEL wird dazu so eingestellt, daß sie gerade diesen Lauf-bzw. Verzögerungszeiten entspricht. Dadurch übernimmt das Schieberegister SR jeweils zum richtigen Zeitpunkt den Wert des sekundären Signals. Je nach verwendetem Typ des Analog-Digital-Wandlers ADC muß auch diesem das gegebenenfalls verzögerte Modulationssignal MS zugeführt werden, damit der Wandler zum richtigen Zeitpunkt eine A/D-Wandlung vornimmt.

Die letzten N Speicherzellen des Schieberegisters SR sind über eine schnelle Bufferschaltung BUF mit der Speichereinheit MEM verbunden. Der Bufferschaltung wird ebenfalls das Triggersignal Tr zugeführt. Tritt ein Triggerimpuls auf, so übernimmt die Bufferschaltung die Inhalte D1,...,DN der letzten N Speicherzellen und übergibt sie an die Speichereinheit. Wenn die Bufferschaltung einen eigenen Zwischenspeicher aufweist, werden die Meßwerte, die sich in den letzten N Speicherzellen des Schieberegisters befanden, quasi "eingefroren" und die Speichereinheit MEM hat genügend Zeit, nämlich bis zum nächsten Triggersignal, um die Meßwerte zu übernehmen. Die Speichereinheit benötigt dadurch keine schnelle Zugriffszeit und kann daher relativ kostengünstig realisiert werden. Zugleich mit den Meßwerten wird auch der zugehörige Wert der Zeitmessung in der Speichereinheit abgelegt. Die Adresse, unter der die Meßwerte und der Zeitmeßwert TA abgespeichert werden, wird durch die an den Speicher angelegten Adreßsignale ADR bestimmt, die ein Adreßzähler AC erzeugt. Da der Adreßzähler mit jedem Triggersignal inkrementiert oder dekrementiert werden muß, wird an seinen Takteingang das Triggersignal Tr angelegt.

Da das Schieberegister SR in den letzten Speicherzellen die Meßwerte des sekundären Signals vor dem Eintreffen des Triggerimpulses enthält, kann man mit dieser Anordnung problemlos auch Vorgänge untersuchen, die vor dem Triggerimpuls abliefen. Ob der Triggerimpuls dabei periodisch eintrifft, spielt keine Rolle, da nur die Aufzeichnung der Meßwerte nicht aber deren Registrierung an das Triggersignal gekoppelt ist. Die Länge des Schieberegisters bestimmt dabei, wie weit man in die "Vergangenheit" zurückschauen kann. Um diese Zeit zu erhöhen, kann man zusätzlich zwischen Analog-Digital-Wandler ADC und Schieberegister SR bzw. vor dem Analog-Digital-Wandler ADC weitere Verzögerungselemente, beispielsweise in Form von FIFO-Speichern (First in first out) bzw. von CCD-Elementen (Charge coupled devices), schalten. Aufbau und Wirkungsweise derartiger Bauelemente sind dem Fachmann bekannt.

Gesteuert und überwacht wird die ganze Anordnung von einer Kontrolleinheit CONT, vorzugsweise einem Rechner. Diese Kontrolleinheit CONT ist insbesondere mit dem Adreßzähler AC und der Speichereinheit MEM verbunden. Sie kann die Ausgangssignale ADR des Adreßzählers steuern und dadurch den Inhalt der Speichereinheit MEM, also alle aufgezeichneten Meßwerte des sekundären Signals SS und die Zugehörigen Zeitmeßwerte auslesen. Die Kontrolleinheit hat auch die Aufgabe, zur Auswertung der Messung die einzelnen registrierten Meßwerte aufgrund der gemessenen Zeitdifferenz den entsprechenden Zeitpunkten des zu messenden Signalverlaufs U zuzuordnen. Fallen mehrere Meßwerte auf einen Zeitpunkt, so kann die Kontrolleinheit eine Mitteilung durchführen. Arbeiten die zu untersuchende Schaltung IC und der Strahlmodulationsgenerator BBG statistisch unabhängig voneinander, so werden die Meßwerte gleichmäßig über die interessierende Zeitachse des zu messenden Spannungsverlaufs U verteilt sein, so daß die Mitteilung einfach durch eine Addition der Meßwerte vorgenommen werden kann. Das so gewonnene Meßergebnis kann die Kontrolleinheit CONT dann auf einem Ausgabegerät CRT, beispielsweise einem Bildschirm oder einem Plotter, darstellen.

Will man nicht nur Meßwerte vor dem Triggerereignis sondern auch welche danach gewinnen, so muß die Übernahme der Speicherinhalte aus dem Schieberegister SR in die Bufferschaltung BUF bzw. die Speichereinheit MEM verzögert gegenüber dem Triggerimpuls erfolgen. Diese Verzögerung kann z. B. durch einen voreinstellbaren Zähler C erfolgen, dessen Takteingang das Modulationssignal zugeführt wird und der durch das Triggersignal freigeschaltet wird. Nach Erreichen des voreingestellten maximalen Zählerstandes K und damit verzögert um die entsprechende Zeit erfolgt dann die Übernahme der Meßwerte des sekundären Signals SS in die speichereinheit MEM. Durch Verändern des voreinstellbaren maximalen Zählerstandes K läßt sich damit der betrachtete Zeitabschnitt in bestimmten Zeit Schritten vor und hinter das Triggerereignis verschieben. Diese Abwandlung der Anordnung von Figur 3 ist in der betreffenden Figur gestrichelt eingezeichnet.

Mit der beschriebenen Anordnung können pro Triggersignal N Meßwerte aufgenommen und später ausgewertet werden. Entsprechend ist das Signal-Rausch-Verhältnis des Meßergebnisses um den Faktor N besser als bei einem herkömmlichen Verfahren nach dem Stand der Technik, das überdies keine Ereignisse vor dem Triggerimpuls messen könnte.

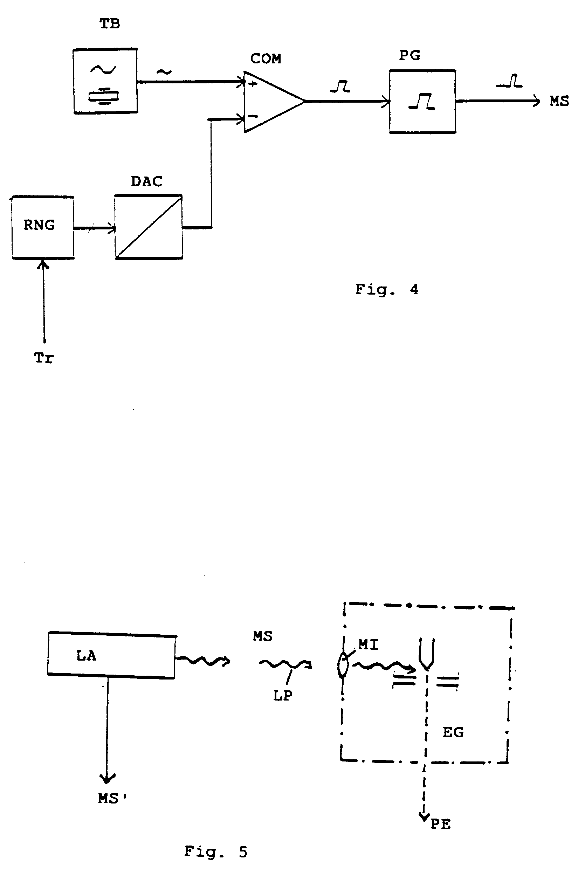

Das erfindungsgemäße Verfahren arbeitet besonders gut, wenn die Modulation des Primärstrahlstromes und der zu untersuchende Vorgang in der Probe statistisch unabhängig voneinander ablaufen. In den meisten Fällen ist diese Bedingung a priori erfüllt. Sollte dies aber einmal nicht der Fall sein, sollten beide Vorgänge etwa phasensynchron ablaufen, so kann man künstlich eine statistische Unabhängigkeit herstellen, indem man das Modulationssignal MS, also das Ausgangssignal des Strahlmodulationsgenerators BBG, künstlich "verjittert". Eine dazu geeignete Ausgestaltung des Strahlmodulationsgenerators zeigt Figur 4. Kernstück bildet eine Zeitbasis TB, die ein Sinussignal erzeugt, das mit dem zu untersuchenden Vorgang korreliert sein darf. Dieses Sinussignal wird dem Komparator COM über seinen ersten Eingang zugeführt. Der Komparator erzeugt aus diesem Sinussignal ein Rechtecksignal gleicher Frequenz, dessen genauer zeitlicher Verlauf von der Ansprechschwelle des Komparators abhängt. Die Ansprechschwelle wird dabei durch die am zweiten Eingang des Komparators anliegende Spannung bestimmt. Verändert man diese Schwelle in zufälliger Weise, so bewirkt dies am Ausgang des Komparators ein "verjittertes" Rechtecksignal, also ein Signal, dessen Phase sich statistisch zufällig verändert. Die statistisch zufällige Variation der Ansprechschwelle kann einfach dadurch erreicht werden, daß man den Ausgang eines Digital-Analog-Wandlers DAG mit dem zweiten Eingang des Komparators COM und den Digitaleingang des Digital-Analog-Wandlers DAC mit dem Ausgang eines digitalen Zufallszahlengenerators RNG verbindet. Aufbau und Wirkungsweise derartiger Zufallszahlengeneratoren sind dem Fachmann aus der Literatur wohlbekannt. Besonders empfehlenswert im Hinblick auf eine Gleichverteilung der Phasenwerte ist dabei der Einsatz eines Zufallszahlengenerators, der arcus-sinusförmig verteilte Zufallszahlen generiert. Der Zufallszahlengenerator RNG liefert fortlaufend Zufallszahlen, die der Digital-Analog-Wandler DAC in entsprechende Spannungswerte umsetzt, die dann über den Komparator COM eine entsprechende Phasenverschiebung des Ausgangssignals bewirken. Die Umschaltung zwischen zwei Zufallszahlen sollte dabei zwischen den einzelnen Messungen vorgenommen werden, damit der konstante Zeitabstand der Primärelektronenimpulse während einer einzelnen Teilmessung erhalten bleibt. Die Umschaltung auf die nächste Zufallszahl wird daher zweckmäßigerweise durch das Triggersignal Tr bewirkt, das hierzu einem Eingang des Zufallszahlengenerators RNG zugeführt wird. Da sich eine Anderung des Schwellwertes des Komparators COM nicht nur auf die Phase des Ausgangssignals sondern auch auf dessen Tastverhältnis auswirkt, kann man das Ausgangssignal des Komparators nicht direkt als Modulationssignal MS benutzen, sondern man muß dem Komparator noch einen Pulsgenerator PG nachschalten, der durch das Ausgangssignal des Komparators getriggert wird. Der Ausgang des Pulsgenerators liefert dann das gewünschte Modulationssignal MS, dessen Pulsbreite bzw. Tastverhältnis sich am Pulsgenerator PG einstellen läßt.

Natürlich sind auch andere Ausführungsformen der Elektronenquelle ES als die in Figur 3 gezeigte möglich. So kann z. B. anstelle der geheizten Kathode, die durch thermische Emission Primärelektronen PE erzeugt, eine Feldemissionskathode treten. Ebenso ist es möglich eine Halbleiterkathode zu verwenden. Bei einer Halbleiterkathode kann die Intensität der Emission sehr einfach durch Variation des Kathodenstroms erfolgen. Ein eigenständiges Strahlmodulationssystem hinter der Kathode kann dann entfallen, und das Modulationssignal MS steuert direkt den Kathodenstrom. Ein weiterer möglicher Aufbau der Elektronenquelle ist schematisch in Figur 5 dargestellt. Hier werden die Primärelektronen PE durch Photoemission aus einer Photokathode erzeugt. Dazu liefert ein Pulslaser LA kurze Lichtimpulse, die über ein in Figur 5 aus Gründen der Übersichtlichkeit nicht dargestelltes Linsensystem durch ein optisches Fenster MI auf die im Vakuum befindliche Photokathode fokussiert werden und aus der Photokathode durch Photoemission kurze PE-Impulse auslösen. Ein Strahlmodulationssystem kann auch in diesem Fall entfallen, da bereits die Erzeugung der PE moduliert erfolgt. Der Modulationseingang MI ist in diesem Fall kein elektrischer sondern ein optischer Eingang und auch das Modulationssignal MS ist ein optisches Signal, denn es wird durch die vom Laser LA ausgehenden Lichtimpulse gebildet. Ein dazu synchrones elektrisches Signal MS' kann in diesem Fall dem Zeitintervallmesser TIM und der übrigen Meßanordnung insbesondere der Meßwertverarbeitungsanordnung MV zugeführt werden. Ein solches Signal MS' kann beispielsweise aus dem Laser LA gewonnen werden. Außerdem ist es möglich, durch einen Teilerspiegel einen Teil der Lichtimpulse des Laser LA auf eine schnelle Photodiode zu leiten und deren Ausgangssignal, das der Modulation des Signals MS entspricht, als Signal MS' zu benutzen.

Der Aufbau der Elektronenquelle ES wird meist besonders einfach, wenn man die Primärelektronenimpulse mit konstantem Zeitabstand erzeugt, da dann die Modulation des Primär-Korpuskularstrahles PE und das Strahlmodulationssystem BBS fest auf die Wiederholfrequenz der Primärelektronenimpulse bzw. ein Vielfaches oder ein Teil davon abgestimmt werden kann. Dies bedeutet einen erheblichen Vorteil gegenüber den herkömmlichen Verfahren, bei denen das Strahlmodulationssystem sehr breitbandig ausgelegt werden muß. Schmalbandige Systeme weisen aber gewöhnlich eine wesentlich höhere Leistungsfähigkeit auf. So kann man beispielsweise mit einer Art Hohlraumresonator mit konstanter Wiederholfrequenz sehr kurze Primärelektronenimpulse erzeugen. Ein solches System ist u.a. in der zuvor zitierten Veröffentlichung von E. Menzel und E. Kubalek beschrieben. Auch wenn man ein herkömmliches, aus einem Plattenkondensator mit nachfolgender Austastapertur bestehendes Strahlmodulationssystem benutzt, kann man die schmalbandige Ansteuerung des Strahlmodulationssystems BBS ausnutzen, indem man diesen Kondensator mit einer zusätzlichen Spule versieht und den dadurch entstehenden Resonanzkreis auf die gewünschte Frequenz abstimmt. Ein solches System kann sehr einfach mit einem Sinussignal bei der Resonanzfrequenz angesteuert werden. Die Spannungsüberhöhung im Resonanzkreis sorgt dann für eine besonders hohe Austastempfindlichkeit und ermöglicht auch die Erzeugung sehr kurzer Primärelektronenimpulse, deren Dauer durch die Amplitude der angelegten Sinusspannung bestimmt werden kann.

Auch die Auswertung der registrierten Meßwerte wird erheblich erleichtert, wenn die Primärelektronenimpulse mit konstantem zeitlichen Abstand periodisch erzeugt werden. Gewöhnlich wird die Auswertung, die die Kontrolleinheit CONT durchzuführen hat, so ablaufen, daß das Zeitfenster, in dem der Spannungsverlauf U gemessen werden soll, in M äquidistante Zeitabschnitte unterteilt und über alle Meßwerte des sekundären Signals SS deren zugehöriger aus dem Meßwert des Zeitintervalls TA ermittelter Meßzeitpunkt in den entsprechenden Zeitabschnitt fällt, gemittelt wird, wobei die verschiedenen dem Fachmann bekannten Mittelungsalgorithmen, wie z. B. die exponentielle Mittelung, angewandt werden können. Diese Auswertung ist zwar nicht kompliziert, wegen der Vielzahl der Meßwerte des sekundären Signals aber im allgemeinen recht aufwendig. Man kann diese Auswertung jedoch durch eine etwas modifizierte Meßverarbeitungsanordnung vereinfachen und dadurch beschleunigen. Dies gilt besonders dann, wenn die Primärelektronenimpulse mit konstanter Wiederholfrequenz erzeugt werden. Eine relativ einfache Anderung der in Figur 3 dargestellten Anordnung genügt bereits, um dieses Ziel zu erreichen. Diese vorteilhafte Ausgestaltung der Erfindung setzt allerdings eine Speichereinheit MEM mit größerem Speicherinhalt als bei der Anordnung nach Figur 3 voraus. Bei dieser Ausgestaltung der Erfindung bestimmen die vom Adreßzähler AC gelieferten Adreßsignale ADR nur einen Teil der Speicheradresse, z. B. nur die höchstwertigen Bits der Adresse. Die übrigen, im angenommenen Beispiel also die niederwertigsten Bits der Adresse, werden dagegen durch das digitalisierte Ausgangssignal TA der Zeitintervallmessung gebildet. Dadurch entspricht nach der Messung die Position der Meßergebnisse im Speicher ihrem zeitlichen Auftreten und die Kontrolleinheit CONT braucht zur Auswertung der Messung nicht mehr die Meßwerte zeitlich zu sortieren, sondern es genügt, wenn sie nur noch über alle Speicherinhalte der Speicherzellen mit den gleichen durch das Ergebnis der Zeitintervallmessung bestimmten Adressteilen mittelt. Selbstverständlich brauchen bei dieser Methode auch die gemessenen Werte des Zeitintervalls nicht explizit abgespeichert zu werden.

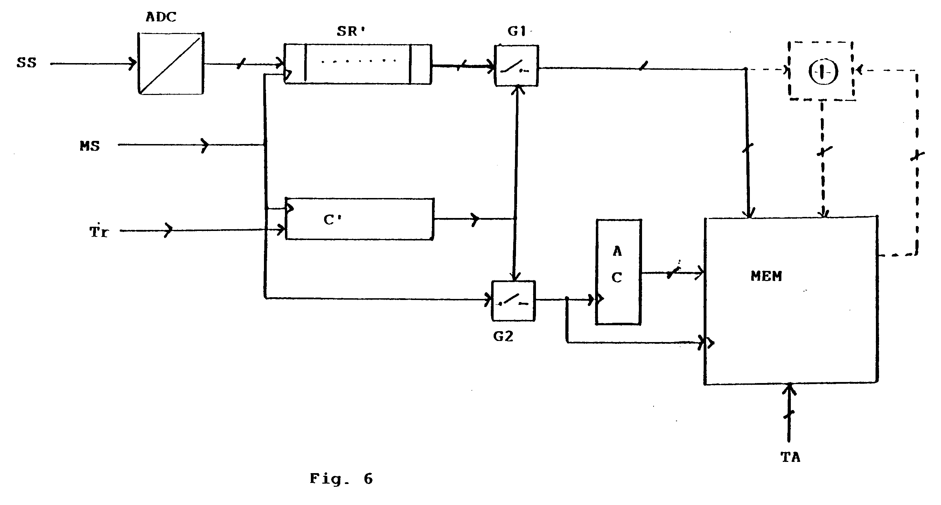

Eine weitere Ausgestaltung der Meßverarbeitungsanordnung zeigt Figur 6. Bei dieser Anordnung werden die zu einem Triggerereignis gehörende Meßwerte nicht parallel, wie in Figur 3, sondern seriell in den Speicher eingelesen, was einen geringeren apparativen Aufwand erfordert, dafür aber u.U. eine Speichereinheit mit schneller Zugriffszeit nötig macht. Die Meßwertverarbeitungsanordnung enthält neben den bereits aus Figur 3 bekannten Teilen zusätzlich einen Zähler C' und zwei Torschaltungen G1 und G2, die im einfachsten Fall als Gatter ausgelegt sind, sowie gegebenenfalls darüberhinaus noch aus einem Addierer. Auch bei dieser Anordnung ist dem Analog-Digital-Wandler ADC, der das sekundäre Signal SS digitalisiert, ein Schieberegister SR' nachgeschaltet, das hier aber nur als Verzögerungselement wirkt, das erforderlich ist, um auch den Spannungsverlauf U vor dem Triggersignal messen zu können. Ist dies nicht erforderlich, kann das Schieberegister SR' ganz entfallen. Ansonsten können an seiner Stelle natürlich auch andere Realisierungen eines Verzögerungsgliedes (CCD-Elemente, FIFO-Speicher etc.) eingesetzt werden. Das Schieberegister SR' ist über eine Torschaltung G1 mit dem Signaleingang der Speichereinheit MEM verbunden, deren Adressen durch die Ausgangssignals ADR des Adreßzählers AC sowie gegebenenfalls, wie schon zuvor für die Anordnung aus Figur 3 beschrieben, durch das digitalisierte Ausgangssignal TA der Zeitintervallmessung bestimmt werden. Dem Zähler C' wird über seinen Takteingang das gegebenenfalls verzögerte Modulationssignal MS bzw. MS' zugeführt. Außerdem erhält er das Triggersignal Tr als Freigabesignal. Bei dem Zähler C' handelt es sich um einen Vorwahlzähler, der nach der Freigabe durch das Triggersignal die Taktimpulse bis zu einer vorwählbaren Zahl N zählt und dann stoppt. Ein Ausgang des Zählers C' ist mit den Steuereingängen der Torschaltungen G1 und G2 verbunden. Befindet sich der Zähler im Zählbetrieb, so öffnet er über diese Verbindungen die beiden Torschaltungen, im anderen Fall sperren die Torschaltungen. Solange kein Triggersignal auftritt, werden daher zwar die zu den einzelnen Primärelektronenimpulsen gehörenden Meßwerte des sekundären Signals registriert und durch das Schieberegister SR' hindurchgeschoben, werden dann aber nicht über die Torschaltung G1 auf die Speichereinheit MEM durchgeschaltet und dort aufgezeichnet. Erst wenn durch ein Triggersignal der Zähler C' freigegeben wird, werden über den Ausgang des Zählers die Torschaltungen G1 und G2 geöffnet, so daß nun die nächsten N am Ausgang des Schieberegisters SR' erscheinenden Meßwerte zur Speichereinheit MEM gelangen und dort abgespeichert werden. Über die geöffnete Torschaltung G2 gelangt dabei das Modulationssignal MS bzw. MS' zum Takteingang des Adreßzählers. Dadurch wird der Adreßzähler bei jedem neuen Meßwert inkrementiert oder dekrementiert, so daß aufeinanderfolgende Meßwerte auch in verschiedenen Speicherzellen abgespeichert werden. Nach N Zyklen des Modulationssignals MS bzw. MS' und damit N Meßwerten des sekundären Signals stoppt der Zähler wieder und kehrt in den Ruhezustand zurück. Dabei sperrt er wieder die beiden Torschaltungen G1 und G2 und unterbindet so ein weiteres Inkrementieren bzw. Dekrementieren des Adreßzählers sowie ein weiteres Abspeichern von Meßwerten.

Ahnlich wie bereits in Zusammenhang mit der Meßwertverarbeitungsanordnung aus Figur 3 erläutert wurde, kann auch bei dieser Anordnung zur Erleichterung der Auswertung das digitalisierte Ausgangssignal TA des Zeitintervallmessers TIM zur Adressierung der Speichereinheit mitbenutzt werden. Wird dies getan, so läßt sich auch die Mittelung durch die Meßwertverarbeitungsanordnung MV selbst durchführen, so daß die Kontrolleinheit entlastet wird. Außerdem kann auf diese Weise die Mittelung bereits sehr einfach während der Messung selbst vorgenommen werden und erfordert keine zusätzliche Rechenzeit. Dazu muß man zwischen die Torschaltung G1 und die Speichereinheit MEM einen Addierer schalten, dessen Eingänge einmal mit dem Ausgang der Torschaltung G1 und zum anderen mit dem Datenausgang der Speichereinheit verbunden ist. Der Ausgang des Addierers ADD wird dagegen auf den Dateneingang der Speichereinheit MEM geschaltet. Wie bereits zuvor beschrieben, werden beim Eintreffen des Triggerimpulses die Torschaltungen G1 und G2 geöffnet und die Meßwerte des sekundären Signals treffen am Eingang des Addierers ADD ein. Zugleich wird über den Adreßzähler AC und gegebenenfalls zusätzlich über das digitalisierte Ausgangssignal TA des Zeitintervallmessers TIM die Speichereinheit MEM adressiert und der aktuelle Speicherinhalt, der die Summe der bis dahin eingetroffenen, dem entsprechenden Zeitpunkt des zu messenden Spannungsverlaufs U zugeordneten Meßwerte, oder allgemeiner eine Mittelung über die Meßwerte angibt, ausgelesen und dem zweiten Eingang des Addierers ADD zugeführt. Der Addierer ADD addiert daraufhin den neu eingetroffenen Meßwert zu den älteren und liest das Ergebnis der Addition wieder in die Speichereinheit MEM ein, wo es daraufhin wieder unter der gleichen Adresse abgespeichert wird.

Manchmal vertragen die zu untersuchenden Proben IC nur eine geringe Belastung durch den Primär-Korpuskularstrahl PE. Bei solchen Proben sollten daher die Anzahl der auf der Probe eintreffenden Primärelektronenimpulse möglichst klein gehalter werden. Dazu kann die Erzeugung der Primärelektronenimpulse oder ihre Weiterleitung zur Probe IC auf ein wählbares Zeitfenster, dessen Lage in Bezug auf das Triggersignal Tr definiert wird, beschränkt werden. Praktisch kann man dies einfach dadurch erreichen, daß man eine Torschaltung vor dem Modulationseingang MI anordnet, die das Modulationssignal sperren kann. Bei der Anordnung von Figur 3 kommt dafür beispielsweise ein PIN-Dioden-Schalter, bei der Anordnung aus Figur 4 eine Pockelzelle in Betracht. Falls der Strahlmodulationsgenerator BBG oder der Pulsgenerator PG über eine "Gated"-Betriebsart verfügt, kann man auch den Gate-Eingang des Generators anstelle einer zusätzlichen Torschaltung ansteuern. Interessiert man sich beispielsweise nur für den Spannungsverlauf U nach dem Triggersignal, so kann man über eine durch das Triggersignal Tr getriggerte Monoflop-Schaltung die Torschaltung bzw. den Strahlmodulationsgenerator BBG nur für diesen interessierenden Zeitraum freischalten. Will man aber auch Vorgänge vor dem Triggerereignis messen, so läßt sich dies nicht anwenden. Weiß man aber, daß der zu messende Signalverlauf U nur mit einer maximalen Wiederholfrequenz auftreten kann, so kann man, wiederum getriggert durch das Triggersignal Tr, die Torschaltung bzw. den Strahlmodulationsgenerator BBG für eine gewisse Zeitspanne (die natürlich kleiner als die minimale Periodendauer des zu messenden Signalverlaufs U sein sollte) nach dem Eintreffen eines Triggerimpulses sperren und dadurch eine unnötige Probenbelastung vermeiden.

Obschon das erfindungsgemäße Verfahren bislang nur für eine Waveform-Messung, bei der der Primär-Korpuskularstrahl nur auf einen einzigen Meßort positioniert wird, beschrieben wurde, läßt es sich prinzipiell bei all den Meßtechniken einsetzen, die ein Stroboskopie- oder Abtastverfahren einsetzen. Im Bereich der Elektronenstrahl-Meßtechnik sind hier zum Beispiel die Verfahren "Logic-State Mapping" und "Timing Diagram" zu nennen. Bei diesen Verfahren rastert der Primär-Korpuskularstrahl PE über einzelne Punkte, eine Zeile oder einen Teil der Fläche der Probe und ist nicht nur stationär auf einen Punkt gerichtet. Will man das erfindungsgemäße Verfahren auch hier einsetzen, so muß man zusätzlich für jeden Triggerimpuls neben den Meßwerten des sekundären Signals SS und dem Ergebnis TA der Zeitintervallmessung auch noch eine Ortsinformation über den Ort, von dem die Meßwerte stammen, aufzeichnen. Wie man eine solche Ortsinformation, etwa in Form der vom Rastergenerator gelieferten Ablenkspannungen, bei einem Elektronstrahl-Meßgerät gewinnt, ist dem Fachmann bekannt. Bei der Auswertung der Messungen kann dann anhand der gespeicherten Ortsinformation jede Einzelmessung eindeutig einem bestimmten Meßort zugeordnet werden. Auch hier sollte eine Mittelung durchgeführt werden, falls mehrere Meßwerte zum gleichen Zeitpunkt vom gleichen Ort aufgezeichnet wurden. Wie sich bei der Messung der Primär-Korpuskularstrahl PE über die Probe bewegt und in welcher Reihenfolge etwa die einzelnen Meßorte abgetastet wurden, ist völlig ohne Bedeutung. Auch braucht die Bewegung des Primär-Korpuskularstrahles PE nicht unbedingt an die Messung gekoppelt zu werden.

Läuft der zu untersuchende Vorgang in der Probe IC periodisch und mit hoher Frequenzkonstanz ab, so kann man die Anzahl der für eine Messung erforderlichen Triggerimpulse und damit auch die Anzahl der erforderlichen Zeitintervallmessungen erheblich verringern, indem man mit hoher Genauigkeit die Periodendauer des zu untersuchenden Vorgangs z.B. mit Hilfe eines Frequenzzählers mißt. Dann können pro Triggerereignis über mehrere Perioden des zu untersuchenden Vorganges hinweg sehr viele Meßwerte des sekundären Signals SS registriert und aufgezeichnet werden. Auch wenn diese Meßwerte aus verschiedenen Perioden des zu untersuchenden Vorganges stammen, lassen sie sich aufgrund des Meßwertes TA der Zeitintervallmessung und der ebenfalls gemessenen Periodendauer des zu untersuchenden Vorganges eindeutig den verschiedenen Zeitpunkten des Spannungsverlaufs U zuordnen. Diese Ausgestaltung des erfindungsgemäßen Verfahrens bietet sich besonders dann an, wenn die Triggerimpulse schneller aufeinander folgen als der Zeitintervallmesser TIM messen kann und/oder falls die Periodendauer des zu untersuchenden Vorganges kürzer ist als der Zeitabstand der Primärelektronenimpulse.

Natürlich können anstelle des in der Beschreibung des erfindungsgemäßen Verfahrens bzw. der erfindungsgemäßen Anordnung zugrundegelegten Potentialkontrasteffekts auch andere Beeinflussungen der und Probe durch den Primär-Korpuskularstrahl ausgenutzt werden. Dazu zählt beispielsweise die Beeinflussung der von einem Primär Korpuskularstrahl PE erzeugten Sekundärelektronen SE durch ein magnetisches Feld. Durch Ausnutzung dieses sogenannten "magnetische Kontrasts" ließe sich etwa die Bewegung magnetischer Domänen in Magnetblasenspeichern untersuchen. Auch muß das sekundäre Signal SS keineswegs von einem Sekundärelektronenstrom herrühren, der mit Hilfe eines Detektors DT gemessen wird. Ebenso ist es beispielsweise möglich, das sekundäre Signal direkt von der Probe IC abzuleiten, indem man z. B. den vom Primärstrahl PE in der Probe induzierten Strom an den Anschlüssen der Probe mißt. Ein Beispiel für eine solche Technik, bei der das erfindungsgemäße Verfahren ebenfalls eingesetzt werden kann, ist die dem Fachmann wohlbekannte EBIC (Electron beam induced current)-Technik.

Zur Gewinnung des sekundären Signals SS kann insbesondere ein Spektrometer SP in die Anordnung eingebracht werden. Besonders gut eignet sich dazu ein Gegenfeldspektrometer, wie es beispielsweise aus der US-Patentschrift 4,292,419 bekannt ist. Wie ein solches Spektrometer zur Gewinnung eines Signals benutzt werden kann, ist dem Fachmann bekannt. Eine besonders einfache Möglichkeit ist z. B. das Anlegen einer konstanten Spannung an das Gegenfeldnetz.

## Patentansprüche

1. Verfahren zur Messung des zeitlichen Verlaufs eines wiederkehrenden Signals (U) an wenigstens einem Meßpunkt einer Probe (IC), auf dem ein den Primärstrahlstrom (I_{PE}) verursachender, zeitlich veränderbarer Primärkorpuskularstrahl (PE) auftrifft, wobie von der Probe ein sekundäres Signal (SS) abgeleitet wird, von dem wenigstens ein Teil registriert wird,
dadurch gekennzeichnet, daß die zeitliche Zuordnung eines Triggersignals (Tr), das in einem definierten zeitlichen Zusammenhang mit dem zu messenden Signalverlauf (U) steht, zu dem Verlauf des Primärstrahlstroms (I_{PE}) gemessen wird und
daß die registrierten Werte des sekundären Signals (SS) entsprechend diesem gemessenen zeitlichen Zusammenhang den Zeitpunkten des zu messenden Signalverlaufs (U) zugeordnet werden.

2. Verfahren nach Anspruch 1,
dadurch **gekennzeichnet,** daß der Primärstrahlstrom (I_{PE}) aus einzelnen Primärstrahlimpulsen gebildet wird.

3. Verfahren nach Anspruch 2,
dadurch **gekennzeichnet,** daß wenigstens eine Gruppe von Primärstrahlimpulsen einen konstanten zeitlichen Abstand (T'') aufweist, und
- daß die Messung der zeitlichen Zuordnung durch eine Messung der Dauer des Zeitintervalls zwischen dem Auftreten des Triggersignals (Tr) und wenigstens einem Zeitpunkt, zu dem ein Primärstrahlimpuls erzeugt wird, erfolgt.

4. Verfahren nach einem der Ansprüche 1 bis 3,
dadurch **gekennzeichnet,** daß die genannten Verfahrensschritte mehrmals durchgeführt werden.

5. Verfahren nach einem der Ansprüche 1 bis 4,
dadurch **gekennzeichnet,** daß über mehrere registrierte Werte des sekundären Signals (SS), die aufgrund der gemessenen zeitlichen Zuordnung nahe beieinanderliegenden Zeitpunkten des zu messenden Signalverlaufs (U) zugeordnet werden, gemittelt wird.

6. Verfahren nach Anspruch 5,
dadurch **gekennzeichnet,** daß diese Mittelung während der Messung selbst vorgenommen wird.

7. Verfahren nach einem der Ansprüche 1 bis 6,
dadurch **gekennzeichnet,** daß der Primärstrahlstrom (I_{PE}) nur in einem Zeitabschnitt, dessen Lage durch das Triggersignal (Tr) bestimmt wird, von Null verschieden ist.

8. Verfahren nach einem der Ansprüche 1 bis 7,
dadurch **gekennzeichnet,** daß die Primärkorpuskel durch thermische Emission erzeugt werden.

9. Verfahren nach einem der Ansprüche 1 bis 7,
dadurch **gekennzeichnet,** daß die Primärkorpuskel durch Feldemission erzeugt werden.

10. Verfahren nach einem der Ansprüche 1 bis 7,
dadurch **gekennzeichnet,** daß die Primärkorpuskel durch Photoemission erzeugt werden.

11. Verfahren nach einem der Ansprüche 1 bis 10,
dadurch **gekennzeichnet,** daß die Phasenlage des Primärstrahlstroms (I_{PE}) während der Messung verändert wird.

12. Verfahren nach einem der Ansprüche 1 bis 11,
dadurch **gekennzeichnet,** daß der Verlauf des Primärstrahlstroms (I_{PE}) verjittert wird.

13. Verfahren nach einem der Ansprüche 1 bis 12,
dadurch **gekennzeichnet,** daß das sekundäre Signal (SS) mit Hilfe eines Detektors (DT) von der Probe abgeleitet wird.

14. Verfahren nach einem der Ansprüche 1 bis 13,
dadurch **gekennzeichnet,** daß das sekundäre Signal (SS) mit Hilfe eines Spektrometers gewonnen wird.

15. Verfahren nach einem der Ansprüche 1 bis 14,
dadurch **gekennzeichnet,** daß aus dem Primärkorpuskularstrahl (PE) unter Nutzung des Potentialkontrasteffekts das sekundäre Signal erzeugt wird.

16. Verfahren nach einem der Ansprüche 1 bis 14,
dadurch **gekennzeichnet,** daß die Beeinflussung des vom Primärkorpuskularstrahl (PE) erzeugten sekundären Signals (SS) unter Nutzung des magnetischen Kontrasteffekts erfolgt.

17. Verfahren nach einem der Ansprüche 1 bis 14,
dadurch **gekennzeichnet,** daß die Beeinflussung des vom Primärkorpuskularstrahl (PE) erzeugten sekundären Signals (SS) unter Nutzung des EBIC-Effekts stattfindet.

18. Verfahren nach einem der Ansprüche 1 bis 17,
dadurch **gekennzeichnet,** daß zusätzlich zu den genannten Verfahrensschritten eine Messung der Periodendauer des zu messenden Signalverlaufs (U) vorgenommen wird und
- daß das Ergebnis dieser Messung zusammen mit der Messung der zeitlichen Zuordnung zwischen Triggersignal und Verlauf des Primärstrahlstroms benutzt wird, um die registrierten Werte des sekundären Signals (SS) den Zeitpunkten des Signalverlaufs (U) zuzuordnen.

19. Verfahren nach einem der Ansprüche 1 bis 18,
dadurch **gekennzeichnet,** daß zusätzlich eine Ortsinformation über den Meßort registriert wird.

20. Verfahren nach Anspruch 19,
dadurch **gekennzeichnet,** daß der Primär-Korpuskularstrahl (PE) über die - Probe (IC) bewegt wird, und
- daß die Ortsinformation die Position des Primärstrahls (PE) auf der Probe (IC) angibt.

21. Verfahren nach einem der Ansprüche 1 bis 20,
dadurch **gekennzeichnet,** daß das Triggersignal (Tr) von einem Funktionstester geliefert wird.

22. Verfahren nach einem der Ansprüche 1 bis 21,
dadurch **gekennzeichnet,** daß es sich bei der Probe (IC) um eine integrierte Schaltung handelt.

23. Anordnung zur Messung des zeitlichen Verlaufs eines wiederkehrenden Signals (U) an wenigstens einem Meßpunkt einer in einem Mikroskop angeordneten Probe (IC),
mit einer Vorrichtung zur Führung und Fokussierung eines modulierten Primär-Korpuskularstrahl (PE), den eine Primärstrahlquelle (ES) erzeugt,
einer Ansteuerung (ICA) zur Versorgung der Probe (IC) mit Versorgungsspannungen und/oder Signalen, und einer Meßwertverarbeitungsanordnung (MV) zur Registrierung und/oder Auswertung von durch das Auftreffen des Primär-Korpuskularstrahls (PE) auf die Probe (IC) erzeugten sekundären Signals (SS),
**gekennzeichnet** durch eine Einheit (TIM) zur Messung der zeitlichen Zuordnung zwischen einem Triggersignal (Tr) und dem Verlauf eines Primärstrahlstroms (I_{PE}), der durch den Primär-Korpuskularstrahl (PE) erzeugt wird.

24. Anordnung nach Anspruch 23,
dadurch **gekennzeichnet,** daß die Primärstrahlquelle (ES) aus einer Elektronenkanone (EG) zur Erzeugung eines unmodulierten Stroms von Primärkorpuskeln und einem nachgeschalteten Strahlmodulationssystem (BBS) besteht.

25. Anordnung nach Anspruch 24,
dadurch **gekennzeichnet,** daß das Strahlmodulationssystem bei Resonanz betreibar ist.

26. Anordnung nach Anspruch 23,
dadurch **gekennzeichnet,** daß die Primärstrahlquelle (ES) eine Elektronenkanone (EG) enthält, die bereits selbst einen modulierten Strom von Primärkorpuskeln erzeugt.

27. Anordnung nach Anspruch 26,
dadurch **gekennzeichnet,** daß die Elektronenkanone (EG) eine Halbleiterkathode enthält, deren Primärkorpuskelemission durch den Strom durch die Kathode gesteuert werden kann.

28. Anordnung nach Anspruch 26,
dadurch **gekennzeichnet,** daß die Elektronenkanone (EG) eine Photokathode enthält, die durch Lichtimpulse (LP) zur Emission von Primärstrahlströmen (I_{PE}) angeregt werden kann.

29. Anordnung nach einen der Ansprüche 23 bis 25,
**gekennzeichnet** durch einen Strahlmodulationsgenerator (BBG), der der Primärstrahlquelle (ES) über einen Modulationseingang (MI) ein Modulationssignal zuführt, durch das eine Modulation des Primärstrahlstroms (I_{PE}) bewirkt wird.

30. Anordnung nach Anspruch 29,
dadurch **gekennzeichnet,** daß der Strahlmodulationsgenerator (BBG) aus folgenden Komponenten aufgebaut ist:
- einer stabilen Zeitbasis (TB),
- einem Komparator (COM), dessen erster Eingang mit einem Ausgang der Zeitbasis (TB) verbunden ist,
- einem Pulsgenerator (PG), dessen Triggereingang mit dem Ausgang des Komparators (COM) verbunden ist, und
- einer Vorrichtung zur Veränderung der Ansprechschwelle des Komparators (COM) in zufälliger Weise.

31. Anordnung nach Anspruch 30,
dadurch **gekennzeichnet,** daß die Vorrichtung zur Veränderung der Ansprechschwelle des Komparators (COM) aus einem digitalen Zufallszahlengenerator (RNG) mit nachgeschaltetem Digital-Analog-Wandler (DAC) aufgebaut ist, wobei der Ausgang des Digital-Analog-Wandlers (DAC) mit einem zweiten Eingang des Komparators (COM) verbunden ist.

32. Anordnung nach Anspruch 29,
**gekennzeichnet** durch folgende Merkmale:
- der Strahlmodulationsgenerator (BBG) enthält einen Pulslaser (LA),
- das Modulationssignal (MS) besteht aus einzelnen Lichtimpulsen (LP),
- der Modulationseingang (MI) ist ein optischer Eingang.

33. Anordnung nach einem der Ansprüche 23 bis 32,
dadurch **gekennzeichnet,** daß die Einheit (TIM) zur Messung der zeitlichen Zuordnung zwischen dem Triggersignal (Tr) und dem Verlauf des Primärstrahlstroms (I_{PE}) aus einem Zeitintervallmesser besteht, dessen erstem Eingang das Triggersignal (Tr) oder ein davon abgeleitetes Signal und dessen zweitem Eingang das Modulationssignal (MS) oder ein davon abgeleitetes Signal (MS') zugeführt wird.

34. Anordnung nach Anspruch 33,
dadurch **gekennzeichnet,** daß als Zeitintervallmesser ein Frequenzzähler benutzt wird.

35. Anordnung nach einem der Ansprüche 23 bis 34,
dadurch **gekennzeichnet,** daß die Meßwertverarbeitungsanordnung (MV) folgende Komponenten enthält:
- einen Analog-Digital-Wandler (ADC) zur Digitalisierung der Werte des sekundären Signals (SS),
- eine Verzögerungseinheit (SR, SR') zur Verzögerung der Werte des digitalisierten sekundären Signals,
- eine Speichereinheit (MEM) zur Aufzeichnung von Werten des digitalisierten sekundären Signals,
- eine Bufferschaltung zur Übertragung der Werte des digitalisierten sekundären Signals (SS) zur Speichereinheit,
- einen Adreßzähler (AC), der wenigstens einen Teil derzur Adressierung der Speichereinheit (MEM) erforderlichen Adreßsignale (ADR) liefert.

36. Anordnung nach Anspruch 35,
dadurch **gekennzeichnet,** daß die Verzögerungseinheit (SR, SR') aus einem Schieberegister besteht.

37. Anordnung nach Anspruch 35,
dadurch **gekennzeichnet,** daß die Verzögerungseinheit (SR, SR') aus einem FIFO-Speicher besteht.

38. Anordnung nach Anspruch 35,
dadurch **gekennzeichnet,** daß die Verzögerungseinheit (SR, SR') aus einem CCD-Bauelement besteht.

39. Anordnung nach einem der Ansprüche 23 bis 38,
dadurch **gekennzeichnet,** daß die Anordnung einen Zähler (C, C') enthält, der freigeschaltet durch das Triggersignal (Tr) oder ein davon abgeleitetes Signal nach einer bestimmten Anzahl von Zyklen des Modulationssignals die Übernahme der registrierten Werte des sekundären Signals (SS) in die Speichereinheit (MEM) stoppt.

40. Anordnung nach einem der Ansprüche 35 bis 39,
dadurch **gekennzeichnet,** daß ein Teil der zur Adressierung der Speichereinheit (MEM) erforderlichen Adreßsignale von der Einrichtung zur Bestimmung des zeitlichem Zusammenhangs zwischen dem Triggersignal (Tr) oder eines davon abgeleiteten Signals und des Primärstrahlstroms (IPE) geliefert wird.

41. Anordnung nach einem der Ansprüche 35 bis 40,
dadurch **gekennzeichnet,** daß die Meßwertverarbeitungsanordnung (MV) einen Addierer (ADD) enthält, der die aktuellen Werte des sekundären Signals zu den in der Speichereinheit (MEM) aufgezeichneten Werten addiert.

## Claims

1. Process of measuring the variation of a recurrent signal (U) in time at at least one measuring point on a specimen (IC) which a primary corpuscular beam (PE) inducing the primary beam current (I_{PE}) and variable in time is incident on, wherein a secondary signal (SS) is derived from the specimen, whereof at least one fraction is recorded,
**characterized** in that the assignment in time of a trigger signal (Tr) is measured, which present a defined time relationship with the signal variation (U) to be measured, to the variation of the primary beam current (I_{PE}), and
that said recorded values of said seconds signal (SS) are attributed to the points of time of the signal variation (U) to be measured in accordance with that measured time relationship.

2. Process according to Claim 1,
**characterized** in that said primary beam current (I_{PE}) is formed by individual primary beam pulses.

3. Process according to Claim 2,
**characterized** in that at least one group of primary beam pulses presents a constant interval in time (T''), and
that the measurement of the assignment in time is realized by a measurement of the duration of the interval between the occurrence of the trigger signal (Tr) and at least one point of time by which a primary beam pulse is generated.

4. Process according to any of Claims 1 to 3, **characterized** in that the aforementioned steps of operation are car
ried out several times.

5. Process according to any of Claims 1 to 4,
**characterized** in that the mean is taken of several recorded values of the secondary signal (SS) which are associated on the basis of the measured assignment in time of closely adjacent points of time of the signal variation (U) to be measured.

6. Process according to Claim 5,
**characterized** in that this mean is taken during the measurement directly.

7. Process according to any of Claims 1 to 6,
**characterized** in that said primary beam current (I_{PE}) is different from zero only during a period whose position is determined by said trigger signal (Tr).

8. Process according to any of Claims 1 to 7,
**characterized** in that the primary corpuscles are produced by thermionic emission.

9. Process according to any of Claims 1 to 7,
**characterized** in that the primary corpuscles are produced by field emission.

10. Process according to any of Claims 1 to 7,
**characterized** in that the primary corpuscles are produced by photo emission.

11. Process according to any of Claims 1 to 10,
**characterized** in that the phase position of said primary beam current (I_{PE}) is varied during the measurement.

12. Process according to any of Claims 1 to 11,
**characterized** in that the variation of said primary beam current (I_{PE}) is jittered.

13. Process according to any of Claims 1 to 12,
**characterized** in that said secondary signal (SS) is derived from the specimen by means of a detector (DT).

14. Process according to any of Claims 1 to 13,
**characterized** in that said secondary signal (SS) is produced by means of a spectrometer.

15. Process according to any of Claims 1 to 14,
**characterized** in that said secondary signal is produced from said primary corpuscular beam (PE), utilizing said potential contrast effect.

16. Process according to any of Claims 1 to 14, **characterized** in that any influence on said secondary signal (SS)
generated by said primary corpuscular beam (PE) is taken by using said magnetic contrast effect.

17. Process according to any of Claims 1 to 14,
**characterized** in that the influence on said secondary signal (SS) generated by said primary corpuscular beam (PE) is taken by using the EBIC effect.

18. Process according to any of Claims 1 to 17,
**characterized** in that in addition to the defined steps of method the period of the signal variation (U) to be measured is measured and that the result of said measurement is used, in combination with the measurement of the assignment in time between said trigger signal and said primary beam current for associating the recorded values of said secondary signal (SS) with the points of time of said signal variation (U).

19. Process according to any of Claims 1 to 18,
**characterized** in that additionally a site information about the measuring site is recorded.

20. Process according to Claim 19,
**characterized** in that said primary corpuscular beam (PE) is moved over said specimen (IC), and that said site information reflects the position of said primary corpuscular beam (PE) on said specimen (IC).

21. Process according to any of Claims 1 to 20,
**characterized** in that said trigger signal (Tr) is supplied by a function tester.

22. Process according to any of Claims 1 to 21,
**characterized** in that said specimen (IC) is an integrated circuit.

23. System for measuring the variation in time of a recurrent signal (U) at at least one measuring point on a specimen (IC) disposed in a microscope,
comprising a device for guiding and focussing a modulated primary corpuscular beam (PE) which is generated by a primary beam source (ES),
a controller (ICA) for supplying said specimen (IC) with supply voltages and/or signals, and
a processor system (MV) processing the measured values for recording and/or analyzing secondary signals (SS) generated by the incidence of said primary corpuscular beam (PE) onto said specimen (IC),
**characterized** by a unit (TIM) for measuring the assignment in time between a trigger signal (Tr) and the variation of a primary beam current (I_{PE}) which is generated by said primary corpuscular beam (PE).

24. System according to Claim 23,
**characterized** in that said primary beam source (ES) consists of an electron gun (EG) for generating an unmodulated current of primary corpuscles and a following beam modulation system (BBS).

25. System according to Claim 24,
**characterized** in that said beam modulation system is adapted to be operated at resonance.

26. System according to Claim 23,
**characterized** in that said primary beam source (ES) includes an electron gun (EG) which as such already generates a modulated current of primary corpuscles.

27. System according to Claim 26,
**characterized** in that said electron gun (EG) includes a semiconductor cathode whose primary corpuscle emission may be controlled by the current flowing through the cathode.

28. System according to Claim 26,
**characterized** in that said electron gun (EG) includes a photo cathode which is adapted to be excited by light pulses (LP) for emitting primary beam currents (I_{PE}).

29. System according to any of Claims 23 to 25,
**characterized** in that a beam modulation generator (BBG) is used, which supplies a modulation signal to said primary beam source (ES) via a modulation input (MI), for achieving a modulation of said primary beam current (I_{PE}).

30. System according to Claim 29,
**characterized** in that said beam modulation generator (BBG) is composed of the following components:
- a stable time base (TB),
- a comparator (COM) whose first input is connected to an output of said time base (TB),
- a pulse generator (PG) whose trigger input is connected to the output of said comparator (COM), and
- a means for varying the response threshold of said comparator (COM) at random.

31. System according to Claim 30,
**characterized** in that said means for varying the response threshold of said comparator (COM) is composed of a digital random number generator (RNG) followed by a digital-analog converter (DAC), with the output of said digital-analog converter (DAC) being connected to a second input of said comparator (COM).

32. System according to Claim 29,
**characterized** by the following features:
- the beam modulation generator (BBG) comprises a pulse laser (LA),
- the modulation signal (MS) consists of individual light pulses (LP),
- the modulation input (MI) is an optical input.

33. System according to any of Claims 23 to 32,
**characterized** in that said unit (TIM) for measuring the assignment in time between said trigger signal (Tr) and the variation of said primary beam current consists of an intervalometer whose first input is supplied with said trigger signal (Tr) or a signal derived therefrom, and whose second input is supplied with said modulation signal (MS) or a signal (MS') derived therefrom.

34. System according to Claim 33,
**characterized** in that a frequency counter is used as intervalometer.

35. System according to any of Claims 23 to 34,
**characterized** in that said processor system (MV) processing the measured values comprises the following components:
- an analog-digital converter (ADC) for digitizing the values of said secondary signal (SS),
- a delaying unit (SR, SR') for delaying the values of said digitized secondary signal,
- a memory unit (MEM) for recording values of said digitized secondary signal,
- a buffer circuit for transferring the values of said digitized secondary signal (SS) to said memory unit,
- an address counter (AC) which provides at least one part of the address signals (ADR) which are required for addressing said memory unit (MEM).

36. System according to Claim 35,
**characterized** in that said delaying unit (SR, SR') consists of a shift register.

37. System according to Claim 35,
**characterized** in that said delaying unit (SR, SR') consists of a FIFO memory.

38. System according to Claim 35,
**characterized** in that said delaying unit (SR, SR') consists of a CCD device.

39. System according to any of Claims 23 to 38,
**characterized** in that the system comprises a counter (C, C') which when released by said trigger signal (Tr) or a signal derived there-from stops the transfer of the recorded values of said secondary signal (SS) into said memory unit (MEM) after a defined number of cycles of said modulation signal.

40. System according to any of Claims 35 to 39,
**characterized** in that one part of the address signals required for addressing said memory unit (MEM) is provided by said means for determining the time relationship between said trigger signal (Tr) or a signal derived therefrom and said primary beam current (I_{PE}).

41. System according to any of Claims 35 to 40,
**characterized** in that said processor system (MV) processing the measured values comprises an adder (ADD) which adds the actual values of said secondary signal to the values recorded in said storage unit (MEM).

## Revendications

1. Procédé de mesure de la variation d'un signal récurrent (U) dans le temps à au moins un point de mesure sur un spécimen (IC) sur lequel est incident un rayon primaire corpusculaire (PE) qui induit un courant de faisceau primaire (I_{PE}) et qui est variable dans le temps, dans lequel procédé un signal secondaire (SS) est dérivé du spécimen, dont au moins une fraction est enregistrée,
**caractérisé** en ce que l'affectation dans le temps d'un signal de déclenchement (Tr) est mesurée, qui présente un rapport en temps défini entre la variation de signal (U) à mesurer et la variation du courant de faisceau primaire (I_{PE}), et
en ce que lesdites valeurs enregistrées dudit signal secondaire (SS) sont appartenantes aux points du temps de la variation de signal (U) à mesurer en correspondance avec ce rapport de temps mesuré.

2. Procédé selon la revendication 1,
**caractérisé** en ce que ledit courant de faisceau primaire (I_{PE}) est formé par des impulsions de rayon primaire individuelles.

3. Procédé selon la revendication 2,
**caractérisé** en ce qu'au moins une groupe d'impulsions de rayon primaire présente un intervalle constante (T'') et
en ce que la mesure de l'affectation en temps se fait par le mesurage de la durée de l'intervalle entre l'apparition du signal de déclenchement (Tr) et au moins un point de temps auquel est engendrée une impulsion de rayon primaire.

4. Procédé selon une quelconque des revendications 1 à 3,
**caractérisé** en ce que les étapes susdites de l'opération sont réalisées plusieurs fois.

5. Procédé selon une quelconque des revendications 1 à 4,
**caractérisé** en ce que la moyenne de plusieurs valeurs enregistrées du signal secondaire (SS) est calbulée, qui sont affectées à la base de l'affectation mesurée en temps de points de temps très proches l'un à l'autre de la variation de signal (U) à mesurer.

6. Procédé selon la revendication 5,
**caractérisé** en ce que cette moyenne est calculée directement au cours de la mesure.

7. Procédé selon une quelconque des revendications 1 à 6,
**caractérisé** en ce que ledit courant de faisceau primaire (I_{PE}) est inégal à zéro seulement pendant une période dont la position est déterminée par ledit signal de déclenchement (Tr).

8. Procédé selon une quelconque des revendications 1 à 7,
**caractérisé** en ce que les corpuscules primaires sont engendrés par émission thermique.

9. Procédé son une quelconque des revendications 1 à 7,
**caractérisé** en ce que les corpuscules primaires sont engendrés par émission par champ électrique.

10. Procédé son une quelconque des revendications 1 à 7,
**caractérisé** en ce que les corpuscules primaires sont engendrés par photoémission.

11. Procédé son une quelconque des revendications 1 à 10, **caractérisé** en ce que la relation de phase dudit courant de faisceau primaire (I_{PE}) est variée au cours de la mesure.

12. Procédé selon une quelconque des revendications 1 à 11,
**caractérisé** en ce que la variation dudit courant de faisceau primaire (I_{PE}) est instabilisée.

13. Procédé selon une quelconque des revendications 1 à 12,
**caractérisé** en ce que ledit signal secondaire (SS) est dérivé du spécimen au moyen d'un détecteur (DT).

14. Procédé son une quelconque des revendications 1 à 13,
**caractérisé** en ce que ledit signal secondaire (SS) est engendré au moyen d'un spectromètre.

15. Procédé selon une quelconque des revendications 1 à 14,
**caractérisé** en ce que ledit signal secondaire est engendré dudit rayon primaire corpusculaire (PE), en utilisant l'effet de contraste de potential.

16. Procédé selon une quelconque des revendications 1 à 14,
**caractérisé** en ce que toute influence sur ledit signal secondaire (SS) engendré par ledit rayon primaire corpusculaire (PE) est prise en utilisant ledit effet de contraste magnétique.

17. Procédé selon une quelconque des revendications 1 à 14,
**caractérisé** en ce que l'influence sur ledit signal secondaire (SS) engendré par ledit rayon primaire corpusculaire (PE) est prise en utilisant l'effet dit EBIC.

18. Procédé selon une quelconque des revendications 1 à 17,
**caractérisé** en ce que, supplémentairement aux opérations définies de la méthode, la période de la variation de signal (U) à mesurer est mesurée, et
en ce que le résultat de ladite mesure est utilisé, en combinaison avec la mesure de affectation en temps entre ledit signal de déclenchement et ledit courant de faisceau primaire, pour affecter les valeurs enregistrées dudit signal secondaire (SS) aux points de temps de ladite variation de signal (U).

19. Procédé selon une quelconque des revendications 1 à 18,
**caractérisé** en ce que supplémentairement une information locale sur le point de mesure est enregistrée.

20. Procédé selon la revendication 19,
**caractérisé** en ce que ledit rayon primaire corpusculaire (PE) est passé sur ledit spécimen (IC), et
en ce que ladite information locale indique la position dudit rayon primaire corpusculaire (PE) sur ledit spécimen (IC).

21. Procédé selon une quelconque des revendications 1 à 20,
**caractérisé** en ce que ledit signal de déclenchement (Tr) est alimenté par un appareil d'essai de fonctionnement.

22. Procédé selon une quelconque des revendications 1 à 21,
**caractérisé** en ce que ledit spécimen (IC) est un circuit intégré.

23. Système de mesure d'une variation dans le temps d'un signal récurrent (U) à au moins un point de mesure sur un spécimen (IC) disposé dans un microscope,
comprenant un dispositif à guider et focaliser un rayon primaire corpusculaire modulé (PE), qui est engendré par une source du rayonnement primaire (ES),
un organe de commande (ICA) pour alimenter les spécimen (IC) en tensions d'alimentation et/ou signaux, et
un système de traitement (MV) pour traiter les valeurs mesurées afin d'enregistrer et/ou analyser des signaux secondaires (SS) engendrés par l'incidence dudit rayon primaire corpusculaire (PE) sur ledit spécimen (IC),
**charactérisé** par une unité chronomètre (TIM) pour mesurer l'affectation en temps entre un signal de déclenchement (Tr) et la variation d'un courant de faisceau primaire (I_{PE}), qui est engendré par ledit rayon primaire corpusculaire (PE).

24. Système selon la revendication 23,
**caractérisé** en ce que ladite source du rayonnement primaire (ES) est composé d'un canon électrique (EG) pour la production d'un courant non-modulé de corpuscules primaires, et un système modulateur de faisceau y suivant (BBS).

25. Système selon la revendication 24,
**caractérisé** en ce que ledit système modulateur de faisceau est approprié à être agencé à résonnance.

26. Système selon la revendication 23,
**caractérisé** en ce que ladite source du rayonnement primaire (ES) comprend un canon électrique (EG) qui produit, de sa part déjà, un courant modulé de corpuscules primaires.

27. Système selon la revendication 26,
**caractérisé** en ce ledit canon électrique (EG) comprend une cathode semiconductrice dont l'émission de corpuscules primaires peut être commandée par le courant qui s'écoule par la cathode.

28. Système selon la revendication 26,
**caractérisé** en ce que ledit canon électrique (EG) comprend une photocathode appropriée à être excitée par des impulsions de photons (LP) pour l'émission de courants de faisceau primaire (I_{PE}).

29. Système selon une quelconque des revendications 23 à 25,
**caractérisé** en ce qu'un générateur de modulation du faisceau (BBG) est employé pour alimenter un signal de modulation à ladite source du rayonnement primaire (ES) via une entrée de modulation (MI), afin d'achever une modulation dudit courant de faisceau primaire (I_{PE}).

30. Système selon la revendication 29,
**caractérisé** en ce que ledit générateur de modulation du faisceau (BBG) est composé des composants suivants:
- une base de temps stabile (TB),
- un comparateur (COM) dont la première entrée est raccordée à une sortie de ladite base de temps (TB),
- un générateur d'impulsions (PG) dont l'entrée de déclenchement est raccordée à la sortie dudit comparateur (COM), et
- un moyens à varier le seuil de réponse dudit comparateur (COM) aléatoirement.

31. Système selon la revendication 30,
**caractérisé** en ce que ledit moyens à varier le seuill de réponse dudit comparateur (COM) est composé d'un générateur numérique de nombres aléatoires (RNG) suivi d'un convertisseur numérique-analogique (DAC), la sortie dudit convertisseur numérique-analogique (DAC) étant reliée à la deuxième entrée dudit comparateur (COM).

32. Système selon la revendication 29,
**caractérisé** par les caractéristiques suivantes:
- le générateur de modulation du faisceau (BBG) comprend un laser impulsionnel (LA),
- le signal de modulation (MS) consiste en des impulsions de photons (LP) individuelles,
- l'entrée de modulation (MI) est une entrée optique.

33. Système selon une quelconque des revendications 23 à 32,
**caractérisé** en ce que ladite° unité chronomètre (TIM) pour la mesure de l'affectation en temps entre ledit signal de déclenchement (Tr) et la variation dudit courant de faisceau primaire est constitué par un chronomètre des intervalles dont la première entrée est alimenté en ledit signal de déclenchement (Tr) ou un signal en dérivé, et dont la deuxième entrée est alimenté en ledit signal de modulation (MS) ou un signal (MS') en dérivé.

34. Système selon la revendication 33,
**caractérisé** en ce qu'un compteur de fréquences est utilisé comme ledit chronomètre des intervalles.

35. Système selon une quelconque des revendications 23 à 34,
**caractérisé** en ce que ledit système (MV) de traitement de valeurs mesurées comprend les composants suivants:
- un convertisseur analogique-numérique (ADC) pour numériser les valeurs dudit signal secondaire (SS),
- une unité de retard (SR, SR') pour retarder les valeurs dudit signal secondaire numérique,
- une mémoire (MEM) pour l'enregistrement de valeurs dudit signal secondaire numérique,
- un circuit de tampon pour le transfert des valeurs dudit signal secondaire numérique (SS) à ladite mémoire,
- un compteur d'allocation (AC) qui fournit au moins une partie de signaux d'adresse (ADR) requis pour l'adressage de ladite mémoire (MEM).

36. Système selon la revendication 35,
**caractérisé** en ce que ladite unité de retard (SR, SR') est composé d'un registre de décalage.

37. Système selon la revendication 35,
**caractérisé** en ce que ladite unité de retard (SR, SR') est composé d'une mémoire type FIFO.

38. Système selon la revendication 35, **caractérisé** en ce que ladite unité de retard (SR, SR') est composé
d'un élément type CCD.

39. Système selon une quelconque des revendications 23 à 38,
**caractérisé** en ce que le système comprend un compteur (C, C') qui, en état débloqué par ledit signal de déclenchement (Tr) ou un signal en dérivé, arrête le transfert des valeurs enregistrées dudit signal secondaire (SS) dans ladite mémoire après un nombre défini de cycles dudit signal de modulation.

40. Système selon une quelconque des revendications 35 à 39,
**caractérisé** en ce qu'une partie des signaux d'adresse requis pour l'adressage de ladite mémoire (MEM) est fournie par ledit moyen à déterminer le rapport en temps entre ledit signal de déclenchement (Tr) ou un signal en dérivé, et ledit courant de faisceau primaire (I_{PE}).

41. Système selon une quelconque des revendications 35 à 40,
**caractérisé** en ce que ledit système de traitement (MV) à traiter les valeurs mesurées comprend un addeur (ADD) qui additionne les valeurs actuelles dudit signal secondaire aux valeurs enregistrées dans ladite mémoire (MEM).
